# FASCICULE DE BREVET EUROPEEN

(11) **EP 2 718 732 B1**
(45) Date de publication et mention de la délivrance du brevet: **29.07.2015**
(21) Numéro de dépôt: 12731104.1
(22) Date de dépôt: 04.06.2012
(51) Int. Cl.: G01R 27/20

(54) **DISPOSITIF ET PROCEDE CORRESPONDANT DE MESURE DE LA RESISTANCE DU RACCORDEMENT A LA TERRE D'UN APPAREIL ELECTRIQUE**
VORRICHTUNG UND ENTSPRECHENDES VERFAHREN ZUR MESSUNG DES WIDERSTANDES DES ERDSCHLUSSES EINER ELEKTRISCHEN VORRICHTUNG
DEVICE AND CORRESPONDING METHOD FOR MEASURING THE RESISTANCE OF THE GROUND CONNECTION OF AN ELECTRICAL DEVICE

(30) Priorité: 08.06.2011 FR 1155014; 14.06.2011 US 201161496682 P
(43) Date de publication de la demande: 16.04.2014
(73) Titulaire: Renault S.A.S., 92100 Boulogne-Billancourt (FR)
(72) Inventeur: RIPOLL, Christophe, F-78460 Chevreuse (FR); CUILLER, Etienne, F-78310 Maurepas (FR); METZELLARD, Olivier, F-63270 Vic Le Comte (FR)
(86) Numéro de dépôt international: PCT/FR2012/051238
(87) Numéro de publication internationale: WO 2012/168634

(56) Documents cités:
- EP-A1- 0 715 172
- EP-A1- 0 864 873
- EP-A2- 0 915 347
- DE-A1-102006 047 960
- GB-A- 2 342 455
- JP-A- 2002 055 147
- JP-A- 2008 164 374
- JP-A- 2009 210 438
- US-A- 4 066 950

## Description

L'invention concerne le raccordement à la terre des appareils électriques et plus particulièrement la mesure de la résistance du raccordement à la terre de ces appareils.

Lors du raccordement à un réseau d'alimentation électrique de certains appareils électriques, un courant de fuite destiné à être redirigé vers la terre peut apparaitre. A titre d'exemple, les chargeurs des batteries des véhicules automobiles à traction électrique ou hybride ne sont pas isolés et peuvent, lors de leur raccordement à un réseau d'alimentation électrique, faire apparaitre un courant de fuite.

Le courant de fuite peut faire apparaitre un courant de toucher sur le châssis électrique des appareils, si le raccordement à la terre est rompu ou si la résistance du raccordement à la terre est trop élevée. Ce courant de toucher est dangereux pour un utilisateur entrant en contact avec le châssis électrique de l'appareil, dans le cas où la résistance du raccordement à la terre est trop importante et si le passage du courant à travers l'utilisateur est favorisé. Par ailleurs, certains appareils électriques peuvent être raccordés à des réseaux d'alimentation monophasés ou triphasés.

Il est donc nécessaire de mesurer la résistance du raccordement à la terre avant d'autoriser l'utilisation de l'appareil électrique à la puissance nominale correspondant à la génération de forts courants de fuite. On parlera également de qualité de la terre comme dans les documents JP 2002 055 147 A et JP 2009 210 438A. Un raccordement de bonne qualité a par exemple une résistance faible.

Des appareils de mesure peuvent être utilisés pour mesurer la résistance du raccordement à la terre. Les appareils existants ont pour inconvénient de ne pas s'adapter au type d'alimentation, le courant généré à travers la résistance du raccordement à la terre n'est pas rebouclé vers le neutre du réseau d'alimentation électrique.

L'invention a donc pour but d'améliorer la mesure de la résistance du raccordement à la terre.

Selon un aspect, il est proposé un dispositif de mesure de la résistance du raccordement à la terre d'un appareil électrique connecté à un réseau d'alimentation monophasé, biphasé ou triphasé, comprenant un générateur de courant apte à générer un courant traversant la résistance du raccordement à la terre. Le réseau d'alimentation est connecté à la terre du côté du transformateur du réseau d'alimentation.

Le dispositif comprend des moyens de mesure de la tension entre le neutre de la connexion au réseau d'alimentation et une prise de terre dudit appareil électrique, ainsi que :
- une branche comportant une résistance montée en série avec une capacité, une borne de ladite branche étant connectée auxdits moyens de mesure,
- et un interrupteur apte à connecter l'autre borne de ladite branche audit neutre de la connexion au réseau d'alimentation.

L'interrupteur permet ainsi de reboucler le courant généré vers le neutre du réseau d'alimentation électrique, et ce pour plusieurs types de réseau d'alimentation électrique. La qualité de la mesure par les moyens de mesure de la résistance du raccordement à la terre est ainsi améliorée.

Avantageusement, le dispositif comprend des moyens de mesure de la tension de chaque liaison électrique de la connexion au réseau d'alimentation électrique.

Cette mesure permet de déterminer la position du neutre ou le type de réseau d'alimentation électrique.

Avantageusement, le dispositif comprend pour chaque liaison de la connexion à un réseau d'alimentation électrique une capacité dont une première électrode est reliée à ladite liaison et dont une deuxième électrode est commune à toutes les capacités et correspond à une position de l'interrupteur.

Ainsi, lors du raccordement à un réseau triphasé sans neutre au moyen de trois liaisons électriques, on peut reconstituer la connexion au neutre.

L'appareil électrique peut être un chargeur de batterie pour un véhicule automobile à traction électrique ou hybride.

Selon un autre aspect, il est proposé un procédé de mesure de la résistance du raccordement à la terre d'un appareil électrique connecté à un réseau d'alimentation monophasé, biphasé ou triphasé, dans lequel on génère un courant à travers la résistance du raccordement à la terre.

Selon une caractéristique générale du procédé, on fait circuler ledit courant vers le neutre de la connexion au réseau d'alimentation électrique, on mesure la résistance du raccordement à la terre en fonction dudit courant, et on connecte préalablement audit neutre de la connexion au réseau d'alimentation par un interrupteur, une borne d'une branche comportant une résistance (12) montée en série avec une capacité (11), l'autre borne de ladite branche étant connectée à des moyens de mesure de la tension entre ledit neutre et une prise de terre dudit appareil.

Avantageusement, on mesure la tension de chaque liaison électrique de la connexion au réseau d'alimentation électrique.

Avantageusement, on fait circuler ledit courant vers une connexion au neutre reconstituée au moyen des liaisons de la connexion à un réseau d'alimentation électrique.

Ainsi, lors du raccordement de l'appareil électrique à un réseau d'alimentation triphasé sans neutre, on peut reconstituer la liaison neutre au moyen de trois capacités et rediriger le courant vers ce neutre reconstitué.

En outre, on peut interdire le fonctionnement de l'appareil électrique si la résistance du raccordement à la terre est supérieure à un seuil défini.

D'autres avantages et caractéristiques de l'invention apparaîtront à l'étude de la description suivante, prise à titre d'exemple non limitatif et illustrée par les dessins annexés sur lesquels:
- les figures 1 à 4 illustrent schématiquement un mode de réalisation et de mise en oeuvre selon l'invention,
- la figure 5 illustre partiellement une électronique de génération d'impulsions de courant,
- et la figure 6 illustre partiellement un shunt de mesure de la tension de terre.

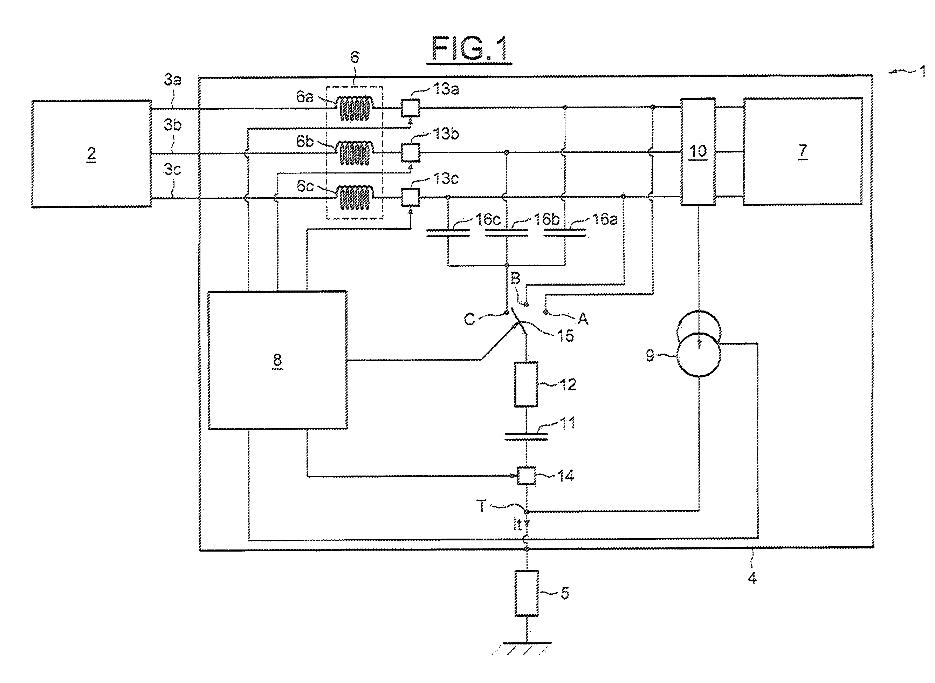

Sur la figure 1, on a représenté un appareil électrique 1 raccordé à un réseau d'alimentation électrique 2 au moyen de trois liaisons conductrices 3a, 3b et 3c. Le réseau d'alimentation électrique 2 peut être un réseau monophasé, biphasé ou triphasé. Les trois liaisons conductrices 3a 3b et 3c peuvent ainsi être traversées par trois phases différentes correspondant à un réseau d'alimentation triphasé sans neutre, ou par une phase et un neutre, ou deux phases pour un réseau d'alimentation biphasé. L'appareil électrique 1 peut avantageusement être un chargeur de batterie pour véhicule automobile électrique ou hybride.

L'appareil électrique 1 est notamment raccordé à la terre par son châssis électrique 4. On a représenté sur la figure la résistance du raccordement à la terre par la résistance 5. Si la résistance du raccordement à la terre est trop élevée, par exemple supérieure à 250 ohm, alors le raccordement à la terre est de mauvaise qualité et une partie des courants de fuite peut former un courant de toucher à la surface du châssis électrique 4.

Un premier filtre 6 est disposé à l'entrée de l'appareil électrique 1 et ce filtre comporte sur chaque liaison 3a, 3b et 3c une inductance 6a, 6b ou 6c. Le filtre 6 peut être par exemple un filtre de compatibilité électromagnétique. Les liaisons 3a, 3b et 3c sont également connectées à un organe principal 7.

Afin de mesurer la résistance du raccordement à la terre, des moyens de mesure 8 de la résistance du raccordement à la terre peuvent être disposés à l'intérieur de l'appareil électrique 1. Les moyens de mesure peuvent également comprendre des moyens de calcul.

Les moyens de mesure contrôlent un générateur de courant 9 connecté entre les liaisons 3a, 3b et 3c par la connexion 10 et également connecté en un point T à la terre par la résistance du raccordement à la terre 5. Afin de réaliser la mesure, une capacité 11 et une résistance 12 sont disposés en série et raccordés à la terre au point T.

Une pluralité de capteurs de tension sont disposés au sein de l'appareil électrique 1. Les capteurs de tension 13a, 13b et 13c sont respectivement disposés sur les liaisons électriques 3a, 3b et 3c, et un capteur de tension 14 est disposé au point T. Les capteurs de tension 13a, 13b, 13c et 14 sont tous reliés aux moyens de mesure 8. Les capteurs de tension 13a, 13b et 13c permettent la mesure des tensions de phase, pour déterminer la nature du réseau d'alimentation (monophasé ou triphasé par exemple) et reconstituer son neutre si nécessaire.

Lorsque le générateur de courant 9 fonctionne, un courant circulant vers la terre It est généré et traverse la résistance du raccordement à la terre 5. L'impédance de la résistance 12 et de la capacité 11 est suffisamment élevée pour que le courant généré par le générateur 9 ne circule que vers la terre. Le courant généré par le générateur 9 reboucle par le réseau d'alimentation. La tension mesurée par le capteur de tension 14 peut donc être considéré comme environ égal à la valeur du courant It circulant vers la terre multipliée par la valeur de la résistance 5 du raccordement à la terre, le capteur de tension 14 mesurant la tension entre le neutre et la prise du terre du véhicule. Afin d'obtenir une mesure exacte de la tension de la terre, mesurée par le capteur de tension 14, il est nécessaire de raccorder la résistance 12 au neutre du réseau d'alimentation électrique. On réduit ainsi les variations de tension aux bornes de la résistance 12, ce qui perturbe moins la mesure du capteur de tension 14.

Afin de raccorder la résistance 12 au neutre du réseau d'alimentation électrique, un interrupteur 15 est connecté à la résistance 12. Cet interrupteur est contrôlé par les moyens de mesure 8, et peut raccorder la résistance 12 avec les points A, B ou C.

Le point C est relié aux trois liaisons 3a, 3b et 3c au moyen de trois capacités 16a, 16b et 16c. Le point B est relié à la liaison 3c et le point A à la liaison 3a.

Si le réseau d'alimentation électrique 2 est un réseau triphasé sans neutre, alors on peut reconstituer le neutre au moyen des trois capacités 16a, 16b, 16c. L'interrupteur 15 est donc relié au point C afin d'améliorer la mesure de la résistance du raccordement à la terre.

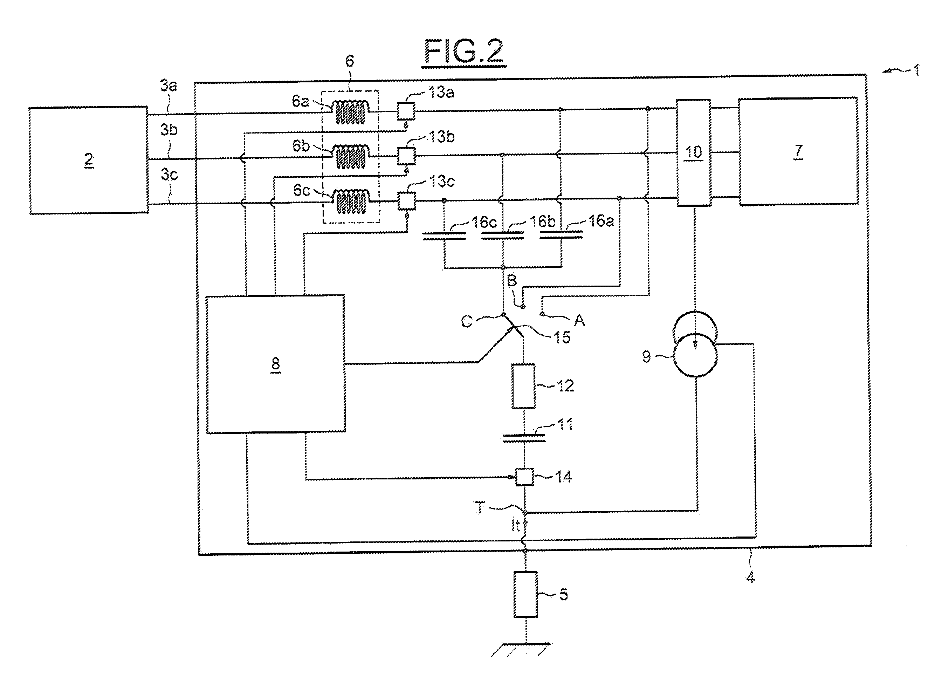

En d'autres termes, si les capteurs 13a, 13b et 13c mesurent trois tensions égales et par exemple de l'ordre de 220 Volts, alors l'interrupteur C se positionne sur le point C, comme illustré sur la figure 2.

Par ailleurs, si le réseau d'alimentation électrique 2 est biphasé, les deux phases étant portées par exemple par les liaisons 3a et 3c, alors on peut obtenir le neutre en positionnant l'interrupteur sur le point C.

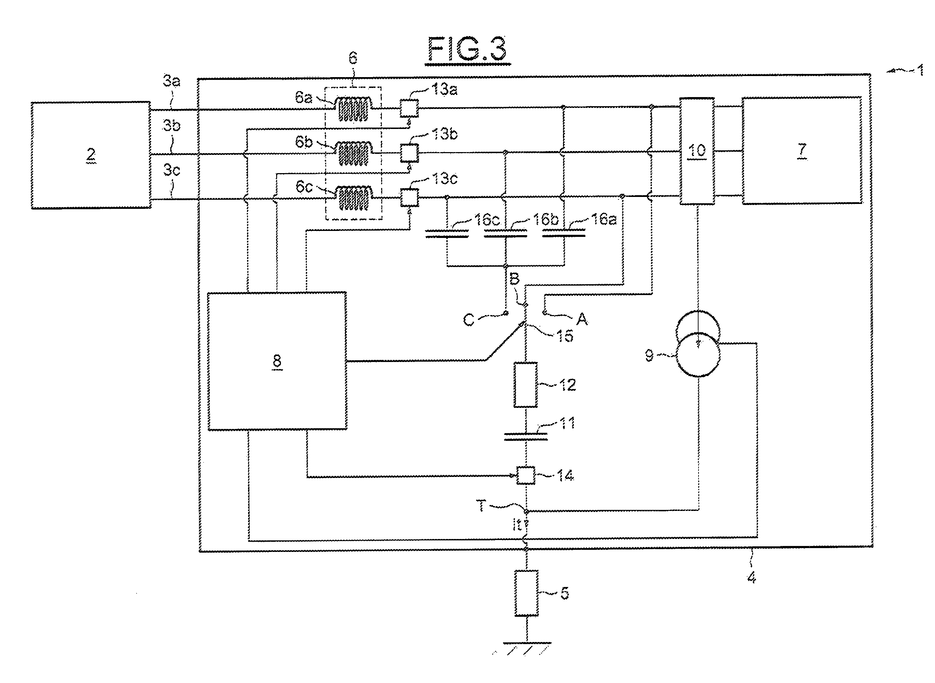

Si le capteur 13a mesure une tension par exemple de l'ordre de 220 Volts et si le capteur 13c mesure une tension nulle, alors le neutre du réseau d'alimentation se trouve sur la liaison 3c et le réseau d'alimentation électrique est un réseau monophasé. On positionne alors l'interrupteur 15 sur la position B (figure 3).

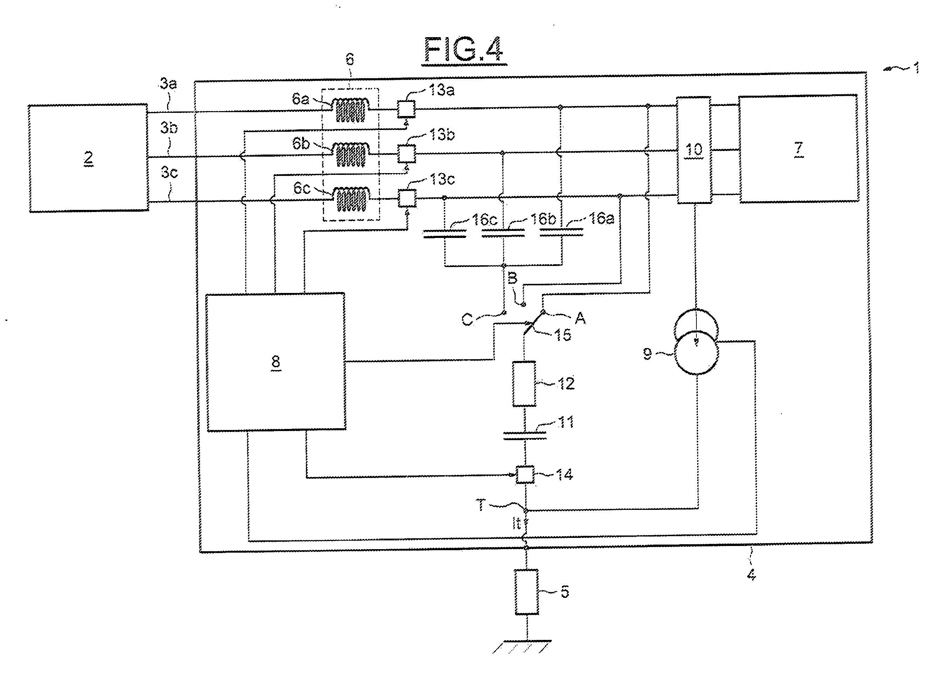

Enfin, si le réseau d'alimentation électrique est monophasé, la phase étant sur la liaison électrique 3c, et le neutre sur la liaison électrique 3a, alors on positionne l'interrupteur 15 sur la position A (figure 4).

On pourra également mesurer la résistance du raccordement à la terre d'un appareil raccordé à un réseau tétraphasé comprenant un neutre. On raccordera alors l'interrupteur au neutre de la connexion tétraphasée.

On peut ainsi mesurer la résistance du raccordement à la terre de manière plus précise. Cette mesure permet d'autoriser ou d'interdire le fonctionnement de l'appareil électrique sous une puissance nominale, lorsque par exemple la résistance mesurée du raccordement à la terre est supérieure à un seuil prédéterminé.

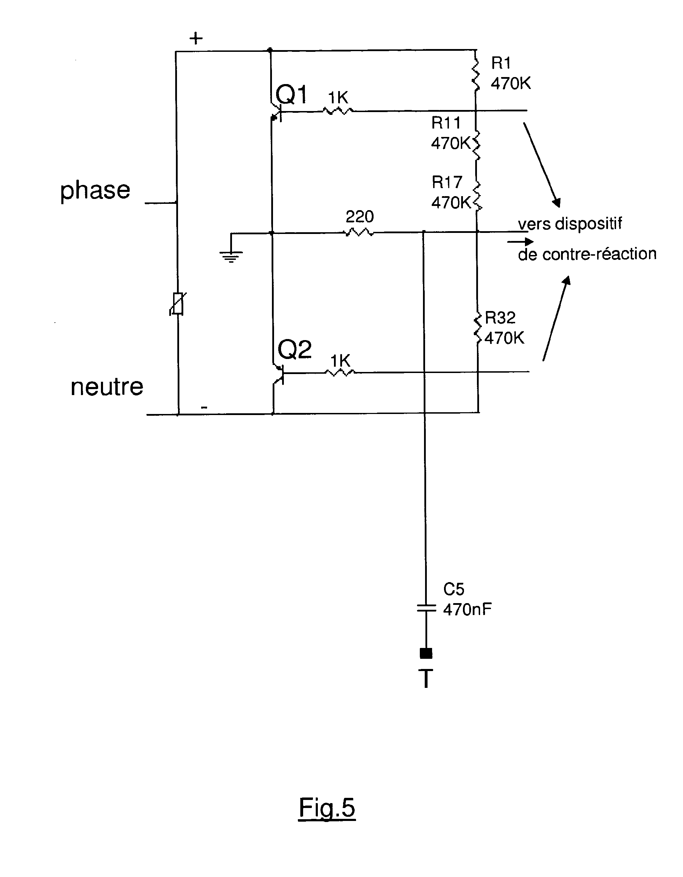

La figure 5 illustre partiellement le générateur de courant 9 :
Le générateur de courant 9 est connecté en entrée à une phase (en configuration triphasée) ou à la phase (en configuration monophasée) du réseau d'alimentation, et au neutre du réseau d'alimentation.

La génération des impulsions sur le châssis (point T) est contrôlée par des transistors Q1 et Q2 au travers d'une capacité C5. La contre-réaction se fait par l'intermédiaire d'amplificateurs opérationnels selon l'état de l'art. Les résistances R1, R11, R17 et R32 permettent à la capacité C5 de maintenir une tension moyenne entre les bus positifs et négatifs (symbolisés respectivement par les symboles + et -) du générateur de courant 9, permettant de générer 20mA entre deux impulsions. En effet ces résistances permettent de décharger la capacité C5 entre deux impulsions de courant, sans saturer le transistor Q1. Les valeurs des résistances indiquées sur la figure 5 sont exprimées en Ohms. Le générateur de courant 9 comprend donc des moyens de maintien d'une tension moyenne entre ses bornes permettant de générer 20mA environ entre deux impulsions, grâce à des moyens de décharge d'une capacité reliant le générateur de courant 9 et la prise de terre T.

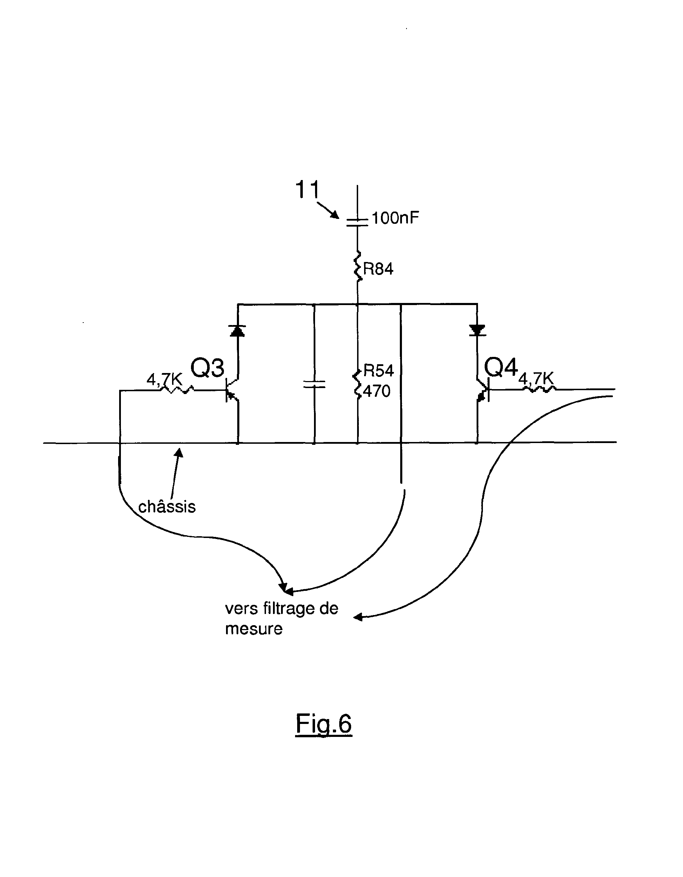

La figure 6 illustre partiellement un shunt de mesure de la tension de terre :
La résistance 12 connectée au châssis pour réaliser la mesure de la tension entre le neutre et la prise de terre du véhicule est constituée des résistances R84 et R54 montées en série. La tension de mesure du shunt est mise à zéro par l'intermédiaire des transistors Q3 et Q4 afin de décharger la capacité 11 entre deux impulsions de courant, cette capacité 11 étant susceptible de se charger du fait des perturbations basse fréquence du réseau d'alimentation. Les valeurs des résistances indiquées sur la figure 6 sont exprimées en Ohms.

## Revendications

1. Dispositif de mesure de la résistance du raccordement à la terre d'un appareil électrique (1) lorsque celui-ci est connecté à un réseau d'alimentation (2) monophasé, biphasé ou triphasé, **caractérisé en ce qu'**il comprend un générateur de courant (9) apte à générer un courant traversant la résistance du raccordement à la terre (5) et rebouclant par le réseau d'alimentation, ledit dispositif de mesure comprenant des moyens de mesure (14) de la tension entre le neutre de la connexion au réseau d'alimentation et une prise de terre dudit appareil électrique, la tension mesurée pouvant être considérée comme environ égale à la valeur du courant circulant vers la terre multipliée par ladite résistance de raccordement à la terre, et **en ce que** ledit dispositif de mesure comprend en outre :
- une branche comportant une résistance (12) montée en série avec une capacité (11), une borne de ladite branche étant connectée auxdits moyens de mesure,
- et un interrupteur (15) apte à connecter l'autre borne de ladite branche audit neutre de la connexion au réseau d'alimentation,
ladite branche étant également reliée à la prise de terre par une desdites bornes.

2. Dispositif selon la revendication 1, comprenant des moyens de mesure de la tension (13a, 13b, 13c) de chaque liaison électrique (3a, 3b, 3c) de la connexion au réseau d'alimentation.

3. Dispositif selon la revendication 1 ou 2, comprenant pour chaque liaison de la connexion au réseau d'alimentation une capacité (16a, 16b, 16c) dont une première électrode est reliée à ladite liaison et dont une deuxième électrode est commune (C) à toutes les capacités et correspond à une position de l'interrupteur.

4. Dispositif selon l'une quelconque des revendications précédentes, dans lequel l'appareil électrique (1) est un chargeur de batterie pour un véhicule automobile à traction électrique ou hybride.

5. Procédé de mesure de la résistance du raccordement à la terre d'un appareil électrique connecté à un réseau d'alimentation monophasé, biphasé ou triphasé, dans lequel on génère un courant à travers la résistance du raccordement à la terre (5), on fait circuler ledit courant vers le neutre de la connexion au réseau d'alimentation électrique en rebouclant par le réseau d'alimentation, on mesure la résistance du raccordement à la terre en fonction dudit courant, **caractérisé en ce qu'**on connecte préalablement audit neutre de la connexion au réseau d'alimentation par un interrupteur, une borne d'une branche comportant une résistance (12) montée en série avec une capacité (11), l'autre borne de ladite branche étant connectée à des moyens de mesure de la tension entre ledit neutre et une prise de terre dudit appareil, ladite branche étant également reliée à la prise de terre par une desdites bornes, la tension mesurée pouvant être considérée comme environ égale à la valeur du courant circulant vers la terre multipliée par ladite résistance de raccordement à la terre.

6. Procédé selon la revendication 5, dans lequel on mesure la tension de chaque liaison électrique (3a, 3b, 3c) de la connexion au réseau d'alimentation électrique.

7. Procédé selon l'une quelconque des revendications 5 ou 6, dans lequel on fait circuler ledit courant vers une connexion au neutre reconstituée au moyen des liaisons de la connexion à un réseau d'alimentation électrique.

8. Procédé selon l'une quelconque des revendications 5 à 7, dans lequel on interdit le fonctionnement de l'appareil électrique si la résistance du raccordement à la terre est supérieure à un seuil défini.

## Patentansprüche

1. Vorrichtung zur Messung des Widerstands des Erdschlusses eines elektrischen Geräts (1), wenn dieses an ein einphasiges, zweiphasiges oder dreiphasiges Versorgungsnetz (2) angeschlossen ist, **dadurch gekennzeichnet, dass** sie einen Stromgenerator (9) enthält, der einen den Widerstand des Erdschlusses (5) durchquerenden und durch das Versorgungsnetz rückschleifenden Strom erzeugen kann, wobei die Messvorrichtung Messeinrichtungen (14) der Spannung zwischen dem Nullleiter des Anschlusses an das Versorgungsnetz und einem Erdleiter des elektrischen Geräts enthält, wobei die gemessene Spannung als in etwa gleich dem Wert des zur Erde fließenden Stroms multipliziert mit dem Erdschlusswiderstand angesehen werden kann, und dass die Messvorrichtung außerdem enthält:
- einen Zweig, der einen mit einem Kondensator (11) in Reihe geschalteten Widerstand (12) aufweist, wobei eine Klemme des Zweigs an die Messeinrichtungen angeschlossen ist,
- und einen Schalter (15), der die andere Klemme des Zweigs an den Nullleiter des Anschlusses an das Versorgungsnetz anschließen kann,
wobei der Zweig durch eine der Klemmen ebenfalls mit dem Erdleiter verbunden ist.

2. Vorrichtung nach Anspruch 1, die Messeinrichtungen der Spannung (13a, 13b, 13c) jeder elektrischen Verbindung (3a, 3b, 3c) des Anschlusses an das Versorgungsnetz enthält.

3. Vorrichtung nach Anspruch 1 oder 2, die für jede Verbindung des Anschlusses an das Versorgungsnetz einen Kondensator (16a, 16b, 16c) enthält, von dem eine erste Elektrode mit der Verbindung verbunden ist und eine zweite Elektrode allen Kondensatoren gemeinsam ist (C) und einer Stellung des Schalters entspricht.

4. Vorrichtung nach einem der vorhergehenden Ansprüche, wobei das elektrische Gerät (1) ein Batterieladegerät für ein Fahrzeug mit Elektro- oder Hybridantrieb ist.

5. Verfahren zur Messung des Widerstands des Erdschlusses eines elektrischen Geräts, das an ein einphasiges, zweiphasiges oder dreiphasiges Versorgungsnetz angeschlossen ist, wobei ein Strom durch den Widerstand des Erdschlusses (5) hindurch erzeugt wird, der Strom zum Nullleiter des Anschlusses an das elektrische Versorgungsnetz fließen gelassen wird, indem über das Versorgungsnetz rückgeschleift wird, der Widerstand des Erdschlusses abhängig vom Strom gemessen wird, **dadurch gekennzeichnet, dass** vorher an den Nullleiter des Anschlusses an das Versorgungsnetz durch einen Schalter eine Klemme eines einen mit einem Kondensator (11) in Reihe geschalteten Widerstand (12) aufweisenden Zweigs angeschlossen wird, wobei die andere Klemme des Zweigs an Messeinrichtungen der Spannung zwischen dem Nullleiter und einem Erdleiter des Geräts angeschlossen ist, wobei der Zweig ebenfalls über eine der Klemmen mit dem Erdleiter verbunden ist, wobei die gemessene Spannung als etwa gleich dem Wert des zur Erde fließenden Stroms multipliziert mit dem Erdschlusswiderstand angesehen werden kann.

6. Verfahren nach Anspruch 5, wobei die Spannung jeder elektrischen Verbindung (3a, 3b, 3c) des Anschlusses an das elektrische Versorgungsnetz gemessen wird.

7. Verfahren nach einem der Ansprüche 5 oder 6, wobei der Strom zu einem Anschluss an den Nullleiter fließen gelassen wird, der mittels der Verbindungen des Anschlusses an ein elektrisches Versorgungsnetz wiederhergestellt wird.

8. Verfahren nach einem der Ansprüche 5 bis 7, wobei der Betrieb des elektrischen Geräts verhindert wird, wenn der Widerstand des Erdschlusses höher ist als eine definierte Schwelle.

## Claims

1. Device for measuring the resistance of the ground connection of an electrical apparatus (1) when the latter is connected to a single-phase, two-phase or three-phase power supply network (2), **characterized in that** it comprises a current generator (9) able to generate a current passing through the resistance of the ground connection (5) and looping back through the power supply network, the said measuring device comprising means (14) for measuring the voltage between the neutral of the connection to the power supply network and a ground pickup of the said electrical apparatus, it being possible for the measured voltage to be considered to be about equal to the value of the current flowing to the ground multiplied by the said ground connection resistance, and **in that** the said measuring device furthermore comprises:
- a branch comprising a resistor (12) mounted in series with a capacitor (11), one terminal of the said branch being connected to the said measuring means,
- and a breaker (15) able to connect the other terminal of the said branch to the said neutral of the connection to the power supply network,
the said branch also being linked to the ground pickup through one of the said terminals.

2. Device according to Claim 1, comprising means for measuring the voltage (13a, 13b, 13c) of each electrical link (3a, 3b, 3c) of the connection to the power supply network.

3. Device according to Claim 1 or 2, comprising for each link of the connection to the power supply network a capacitor (16a, 16b, 16c), a first electrode of which is linked to the said link and a second electrode of which is common (C) to all the capacitors and corresponds to a position of the breaker.

4. Device according to any one of the preceding claims, in which the electrical apparatus (1) is a battery charger for an automotive vehicle with electric or hybrid traction.

5. Method for measuring the resistance of the ground connection of an electrical apparatus connected to a single-phase, two-phase or three-phase power supply network, in which a current is generated through the resistance of the ground connection (5), the said current is made to flow to the neutral of the connection to the electrical power supply network while looping back through the power supply network, the resistance of the ground connection is measured as a function of the said current, **characterized in that** a terminal of a branch comprising a resistor (12) mounted in series with a capacitor (11) is connected beforehand to the said neutral of the connection to the power supply network through a breaker, the other terminal of the said branch being connected to means for measuring the voltage between the said neutral and a ground pickup of the said apparatus, the said branch also being linked to the ground connection through one of the said terminals, it being possible for the said measured voltage to be considered to be about equal to the value of the current flowing to the ground multiplied by the said ground connection resistance.

6. Method according to Claim 5, in which the voltage of each electrical link (3a, 3b, 3c) of the connection to the electrical power supply network is measured.

7. Method according to any one of Claims 5 or 6, in which the said current is made to flow to a connection to the neutral reconstituted by means of the links of the connection to an electrical power supply network.

8. Method according to any one of Claims 5 to 7, in which operation of the electrical apparatus is prohibited if the resistance of the ground connection is greater than a defined threshold.
